# EUROPEAN PATENT APPLICATION

(11) **EP 4 823 268 A1**
(43) Date of publication of application: **14.10.2026**
(21) Application number: 25168748.9
(22) Date of filing: 07.04.2025
(51) Int. Cl.: H10B 43/27, H10D 64/01

(54) **A METHOD FOR FORMING A MEMORY STRUCTURE FOR A 3D NAND FLASH MEMORY**

(71) Applicant: IMEC VZW, 3001 Leuven (BE)
(72) Inventor: RACHIDI, Sana, 3000 Leuven (BE); ROSMEULEN, Maarten, 9000 Gent (BE); ARMINI, Silvia, 3001 Heverlee (BE); VAN DEN BOSCH, Geert, 3010 Kessel-Lo (BE)
(74) Representative: Lind Edlund Kenamets Intellectual Property AB

(57) **Abstract**

According to an aspect, there is provided a method for forming a memory structure for a 3D NAND flash memory, the method comprising:
forming a layer stack over a substrate, the layer stack comprising an alternating sequence of gate layers and inter-gate spacer layers;
forming recessed areas in a sidewall surrounding a memory hole in the layer stack by laterally etching back the gate layers relative to the inter-gate spacer layers from the memory hole;
forming an initial charge trap layer in each recessed area;
depositing a tunneling oxide layer in the memory hole;
depositing a channel layer on the tunneling oxide layer;
forming an access trench in the layer stack;
forming gate cavities in the layer stack by laterally etching back the gate layers from the access trench in a direction towards the memory hole, wherein the gate cavities expose the initial charge trap layers;
oxidizing a portion of the initial charge trap layer in each gate cavity such that the oxidized portion forms a blocking oxide layer and a non-oxidized portion of the initial charge trap layer remains to form a final charge trap layer between the blocking oxide and the memory hole; and
subsequent to forming the blocking oxide layer and the final charge trap layers, forming gate layers in the gate cavities by depositing gate material in the gate cavities via the access trench.

## Description

### TECHNICAL FIELD

The present invention generally relates to a method for forming a memory structure for a 3D NAND flash memory.

### BACKGROUND

The bit density in the 3D NAND flash memory road map increases every year. This far, the increase has been enabled by increasing the number of stacked memory cells along the vertical dimension. However, this route is becoming increasingly difficult and costly. Hence, there is increasing interest in techniques for scaling the cells along the vertical dimension. Vertical scaling ("z-pitch scaling") is achieved by reducing the thickness of the layers in the layer stack, e.g. the word line (gate) layers and oxide inter-gate spacer layers.

Current 3D NAND technology is often based on the so-called charge trap cell utilizing a charge trap layer (e.g. of SiN) as a storage layer. The charge trap layer is separated from the gate layers by a blocking oxide layer. Traditionally, the charge trap layer and the blocking oxide layer have been deposited as continuous layers along the sidewall of the memory hole in the layer stack. Z-scaling results in a reduced inter-cell separation which in turn may reduce the retention performance of the continuous charge trap layer. There is hence a need for scalable techniques allowing forming of an interrupted charge trap layer such that each memory cell may be provided with a separate charge trap layer.

### SUMMARY

A straightforward approach for forming an interrupted charge trap layer would be to, in sequence: recess the gate layers of the memory stack relative to the inter-gate spacer layers from the memory hole by an isotropic etch, deposit a continuous blocking oxide layer along the sidewall of the memory hole and in the recesses, cut the continuous blocking oxide layer by an isotropic etch back to form a discrete blocking oxide layer in each recess, deposit a continuous charge trap layer along the sidewall of the memory hole and in the recesses, and cut the continuous charge trap layer by an isotropic etch back to form a discrete charge trap layer on the blocking oxide layer in each recess. However, this way of processing would require two very highly controlled isotropic etch back processes to uniformly cut the blocking oxide and charge trap layers. It is envisaged such process control would be unattainable, or at least very challenging, to obtain at the scaled z-pitches considered in the future 3D NAND roadmap.

In view of the above, it is an object to address this challenge and provide methods allowing reliable forming of interrupted / cut blocking oxide and charge trap layers also at aggressive z-pitch scaling. **In** particular, it is an object to enable this while obviating the need for two highly controlled isotropic etch back processes for cutting the continuous blocking and charge trap layers, or at least reducing the number of such etch processes needed.

Hence, according to an aspect of the present invention, there is provided a method for forming a memory structure for a 3D NAND flash memory, the method comprising:
forming a layer stack over a substrate, the layer stack comprising an alternating sequence of gate layers and inter-gate spacer layers;
forming recessed areas in a sidewall surrounding a memory hole in the layer stack by laterally etching back the gate layers relative to the inter-gate spacer layers from the memory hole;
forming an initial charge trap layer in each recessed area;
depositing a tunneling oxide layer in the memory hole;
depositing a channel layer on the tunneling oxide layer;
forming an access trench in the layer stack;
forming gate cavities in the layer stack by laterally etching back the gate layers from the access trench in a direction towards the memory hole, wherein the gate cavities expose the initial charge trap layers;
oxidizing a portion of the initial charge trap layer in each gate cavity such that the oxidized portion forms a blocking oxide layer and a non-oxidized portion of the initial charge trap layer remains to form a final charge trap layer between the blocking oxide and the memory hole; and
subsequent to forming the blocking oxide layer and the final charge trap layers, forming gate layers in the gate cavities by depositing gate material in the gate cavities via the access trench.

The method according to the present aspect enables forming of a memory structure comprising vertically separated lateral memory stacks, each comprising a respective discrete blocking oxide layer and a respective discrete charge trap layer for each gate layer or, equivalently, for each memory cell.

Rather than depositing a continuous blocking oxide layer in the recessed areas and subsequently "cutting" the blocking oxide layer into a number of discrete portions by etching, the method forms the discrete blocking oxide layers by oxidizing a portion of the initial charge trap layers. The initial charge trap layers are accessed via a radially outer access trench and gate cavities formed between the inter-gate spacer layers by removing the "sacrificial" gate layers. Hence, discrete blocking oxide layers may be formed at each gate level without a separate deposition and etching of a continuous blocking oxide layer.

This enables reduced process variability since the thickness (in the lateral direction) of the blocking oxide layers may be precisely controlled via the extent/depth of the oxidation of the initial charge trap layers. This may be easier than achieving precise thickness control by deposition and etch back of blocking oxide material in recessed areas from the memory hole.

The reduced process variability in turn facilitates forming of discrete charge trap layers. A common material choice for the inter-gate spacer layers is an oxide (typically silicon oxide). Therefore, it is envisaged that area-selective deposition (ASD) of charge trap material on previously deposited blocking oxide layers in the recessed areas would be challenging without any appreciable concurrent deposition on the inter-gate spacer layers. However, as the charge trap layers according to the present method are formed prior to forming the blocking oxide layers, the gate layers may still be accessed from the memory hole. The gate layers may provide a material contrast to inter-gate spacer layers, e.g., by being formed of a non-oxide material such as a nitride, e.g., silicon nitride, amorphous silicon (a-Si) or polysilicon. Thus, the gate layers may facilitate achieving deposition of charge trap material with a sufficient area selectivity to allow ASD of charge trap material in the recessed areas. Embodiments for ASD of discrete charge trap layers in the recessed areas are set out below.

The reduced process variability conferred by the oxidation-based approach for forming the blocking oxide layers facilitates forming of discrete charge trap layers in the recessed areas also using non-ASD approaches, as further set out herein.

In view of the above, regardless of whether the charge trap layers are formed using ASD or non-ASD approaches, the method hence limits the number of deposition and etch back processes needed to form discrete blocking oxide layers.

The method of the present aspect enables the above discussed advantages with little impact on the overall process complexity. This since, the access trench and gate cavities subsequently are used to provide the functional gate material, e.g., a replacement metal gate (RMG) layer or stack at each gate level.

In some embodiments, the method further comprises:
prior to forming the initial charge trap layers, forming an etch stop layer on the etched-back gate layers in the recessed areas; and
subsequently depositing the initial charge trap layer in each recessed area, on the etch stop layer.

The provision of an etch stop layer further contributes to improved process control, since the lateral etch back of the gate layers from the access trench thus may be reliably stopped on the etch stop layer. This may contribute to more uniform gate cavities, also in scenarios where the gate layers and the initial charge trap layers are formed of materials with little to no etch contrast (such as where both are formed of silicon nitride). In any case, the etch stop layer may serve to mask the initial charge trap layers from the etching chemistries used to etch the gate layers.

The method may further comprise, prior to oxidizing the portion of the initial charge trap layer in each gate cavity, opening the etch stop layer to expose the initial charge trap layer. The initial charge trap layer may thus be exposed to the oxidizing ambient or chemistries of the subsequent oxidation process.

In some embodiments, the etch stop layer is deposited in each recessed area by a (first) area-selective deposition process.

Hence, etch stop layers may be deposited by ASD of etch stop material in each recessed area. During the ASD of etch stop material, the gate layers define deposition-promoting (seeding) areas while the inter-gate spacer layers define deposition-inhibiting (non-growth) areas (e.g., after being subjected to surface passivation), thereby contributing to a selective deposition of the blocking oxide material in the recessed areas.

In some embodiments, the initial charge trap layer is deposited on the etch stop layer in each recessed area by a (second) area-selective deposition process.

Thus, rather than depositing a continuous charge trap layer and subsequently "cutting" the charge trap layer into a number of discrete portions by etching, discrete charge trap layers may be "directly" deposited in the recessed areas by ASD , wherein the (discrete) etch stop layers in the recessed areas define seeding (deposition-promoting) areas ("growth areas") while the inter-gate spacer layers define deposition-inhibiting (non-growth) areas (e.g., after being subjected to surface passivation), thereby contributing to a selective deposition of the charge trap material of the charge trap layers. Deposition of the charge trap material in areas vertically between the gate layers may hence be avoided (i.e., on end surfaces of the inter-gate spacer layers facing the memory hole), thus obviating the need for cutting a continuous layer of charge trap material by etching. By obviating the need for cutting the charge trap material by etching, the lateral thickness of the charge trap layers (i.e., the thickness dimension as seen along the lateral direction) may be precisely controlled by maintaining the growth conditions of the selective deposition until a target thickness has been achieved.

In some embodiments, the portion of the initial charge trap layers are oxidized by a thermal oxidation process. The blocking oxide layers may thus be formed using a simple, reliable and cost-effective process which further may be relatively benign to non-targeted layers, such as the inter-gate spacer layers. A thermal oxidation process may also facilitate a reliable oxidation in high-aspect ratio structures.

In some embodiments, the portion of the initial charge trap layer is oxidized by a plasma oxidation process.

In some embodiments, the access trench is formed after depositing the tunneling oxide layer and the channel layer. This enables a rational overall process flow, obviating the need for a separate covering and reveal of the charge trap layers from the memory hole prior to and after, respectively, forming the blocking oxide layer.

In some embodiments, the method further comprises filling the memory hole with a plug material prior to forming the access trench. The charge trap layers and, if present the tunneling oxide and channel layers, may thus be covered from the side of the memory hole prior to forming the access trench.

In some embodiments, the plug material comprises an oxide. This may be advantageous particular when the plug material is deposited after forming the tunneling oxide and channel layers. The oxide may thus remain as an insulating filler in the memory hole of the finished memory structure.

In some embodiments comprising forming of an etch stop layer, the etch stop layer comprises a metal oxide or a metal nitride. Such etch stop materials (e.g., aluminum oxide, hafnium oxide, titanium oxide or titanium nitride) facilitate process control as they may provide sufficient etch contrast with respect to typical sacrificial gate layer materials and charge trap materials. Further, they may define efficient deposition-promoting surfaces with respect to ASD of the charge trap material, notably relative to non-metal oxide or non-metal nitride (typically silicon oxide) inter-gate spacer layers. Further metal oxides or metal nitrides may be reliably deposited by ASD on typical sacrificial gate layer materials.

In some embodiments, the etch stop layer is formed with a (lateral) thickness of 2 nm or less. Since the etch stop layer is only to function as an etch stop layer and, optionally, seeding layer for ASD of charge trap material, it may be formed as a relatively thin layer. The etch stop layer need hence not unnecessarily encroach upon the depth of the recessed areas available for the initial charge trap layers.

In some embodiments, the initial charge trap layers are silicon-comprising layer, such as silicon nitride layers. Silicon-comprising layers are suitable for charge trap layers. Silicon nitride in particular represents an efficient and rational realization of charge trap-based memory cells. Further, silicon nitride is suitable for ASD onto conformal metal oxides or metal nitrides, without causing any appreciable co-deposition onto silicon oxide. Silicon-comprising layers (such as silicon nitride) may also be oxidized (e.g., in a thermal process) to form a high quality blocking oxide.

### BRIEF DESCRIPTION OF THE DRAWINGS

The above, as well as additional objects, embodiments, features and effects of the present invention, may be better understood through the following illustrative and non-limiting detailed description, with reference to the appended drawings. In the drawings like reference numerals will be used for like elements unless stated otherwise.
Fig. 1a-b schematically shows a schematic cross-sectional view, and a top-down view, respectively, of a starting structure for forming a memory structure according to an embodiment.
Fig. 2 shows the structure after forming recessed areas.
Fig. 3 shows the structure after forming etch stop layers in the recessed areas.
Fig. 4 shows the structure after forming initial charge trap layers in the recessed areas.
Fig. 5 shows the structure after forming tunnel barrier and channel layers, and plugging the memory hole.
Fig. 6 shows the structure after removing an access trench in the layer stack.
Fig. 7 shows the structure after forming gate cavities.
Fig. 8 shows the structure after opening the etch stop layers in the gate cavities.
Fig. 9 shows the structure after partially oxidizing the etch stop layers to form blocking oxide layers in each gate cavity.
Fig. 10 shows the structure after filling the gate cavities with gate material.

### DETAILED DESCRIPTION

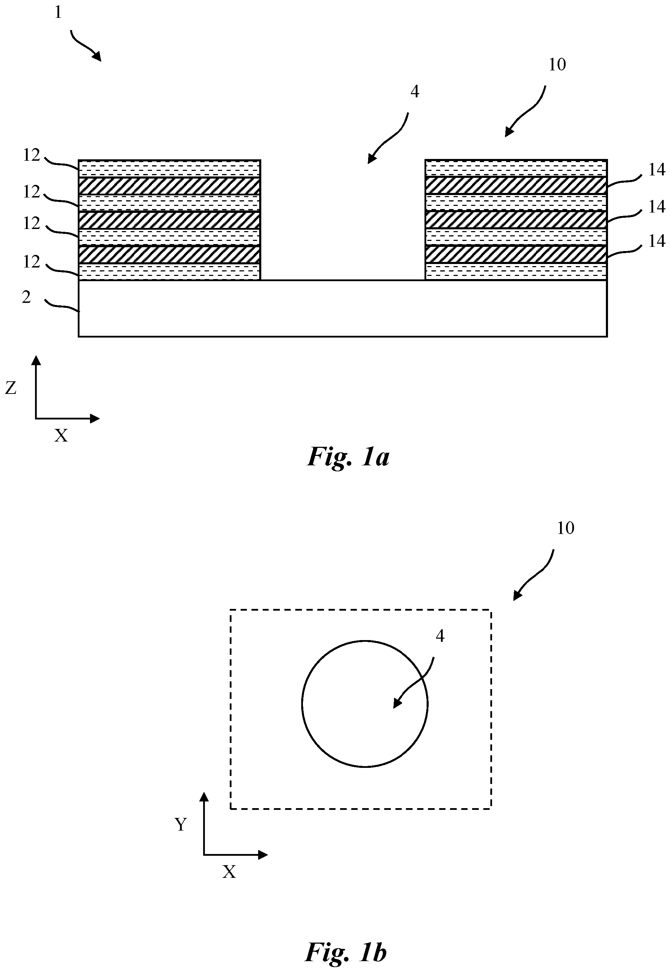

Embodiments of a method for forming a memory structure for a 3D NAND flash memory, such as a 3D-Gate-All-Around-NAND (3D GAA NAND), will now be described with reference to the drawings. The drawings are only schematic and the relative dimensions of some structures and layers may be exaggerated and not drawn to scale. Rather the dimensions may be adapted for illustrational clarity and to facilitate understanding. When present in the figures, the indicated axes X, Y and Z consistently refer to a first horizontal or lateral direction, a second horizontal or lateral direction, and a vertical direction, respectively. As used herein, the terms "horizontal" and "lateral" refer to directions parallel to (a main surface of) a supporting substrate of the memory structure. A lateral/horizontal direction may also be understood as a direction parallel to an in-plane direction of the gate and inter-gate spacer layers. The term "vertical" refers to a direction parallel to a normal direction to (the main surface of) the substrate, i.e. transverse to the substrate. Reference is herein also made to a "radial" direction. This term is to be understood as a radial direction with respect to a given memory hole (e.g., the memory hole 4 in Fig. 1a), parallel to the horizontal XY-plane. The terms "radially inward" and "radially outward" accordingly refers to radially inward and outward directions, respectively, with respect to a given memory hole. Related terms, such as "radially inner", "radially and "radially outer" may correspondingly be used to indicate a relative radial location or distance of a feature or element, relative to the given memory hole.

Fig. 1a-b schematically shows a schematic cross-sectional view, and a top-down view, respectively, of a structure 1 at an initial stage of the method. The structure 1 comprises a layer stack 10 representing a precursor or starting structure for the memory structure, to be subjected to the processing steps of the method disclosed in the following.

The layer stack 10 is formed over a substrate 2 and comprises an alternating sequence of gate layers 14 and inter-gate spacer layers 12. The inter-gate spacer layers 12 and the gate layers 14 are stacked on top of each other along the vertical direction Z.

The substrate 2 may be a conventional substrate, suitable for semiconductor processing and for supporting a memory structure for a 3D NAND flash memory. The substrate 2 may for instance be a Si substrate, a Ge substrate or a SiGe substrate. Other examples include a silicon-on-insulator (SOI) substrate, a GeOI substrate or a SiGeOI substrate.

The gate layers 14 may be silicon-comprising layers, such as SiN layers, a-Si layers, a-Si layers or polysilicon layers. The gate layers 14 are sacrificial gate layers intended to be replaced by an RMG stack in subsequent process steps.

The inter-gate spacer layers 12 may be oxide-comprising layers, typically silicon oxide (e.g., SiO₂) layers or another suitable inter-layer dielectric (e.g. of low-k). The inter-gate spacer layers 12 are arranged in the layer stack 10 to provide vertical separation between the memory cells / word lines of the memory device which is to be formed.

The layer stack 10 may be formed by interchangeably depositing layers of gate material (e.g. nitride) and inter-gate spacer material (e.g. oxide) using deposition processes which per se are known in the art, such as chemical vapor deposition (CVD), physical vapor deposition (PVD) or atomic layer deposition (ALD).

The inter-gate spacer layer 12 and the gate layers 14 may be formed in numbers in accordance with the intended number of stacked memory cells of the memory device. It is to be noted that the number of layers 12, 14 of the illustrated layer stack 10 merely is a non-limiting example and that the method disclosed herein is compatible with stacks of memory cells of essentially any number currently used, or contemplated, in the industry, such as 64, 128, 256 or greater.

The inter-gate spacer layers 12 and the gate layers 14 may each be formed with a respective layer thickness in a range of 5-25 nm, as an example. A z-pitch of the layer stack 10 (i.e. the combined thickness of one inter-gate spacer layer and one gate layer 14) may be in a range from about 45 nm to 15 nm or less.

While omitted for ease of illustration, the layer stack 10 may optionally be capped by a capping layer, for instance a semiconductor layer (e.g., silicon), deposited on top of the top-most inter-gate spacer layer 12. A capping layer may serve to protect the top-most inter-gate spacer layer 12 during the following processing.

After depositing the layers 12 and 14 (and optionally a capping layer) of the layer stack 10, a memory hole 4 may be patterned in the layer stack 14, e.g. by a lithography and etching process. While Fig. 1a-b shows a portion of the layer stack 10 surrounding a single memory hole 4, it is noted that a corresponding memory hole 4 may be patterned at each location where a respective vertical string of memory cells is desired. The memory hole 4 may as shown be formed to extend through each one of the inter-gate spacer layers 12 and gate layers 14 of the layer stack 10. The memory hole 4 may as further shown in the top-down view of Fig. 1b be formed with a circular cross-sectional shape (footprint), such that the memory hole 4 may be formed with a substantially circular cylindrical shape. However, the memory hole 4 may also be formed with other cross-sectional shapes, such as an oval or polygonal shape.

While not shown in Fig. 1a, the layer stack 10 may as per se is known in the art further comprise, underneath the layers 12, 14, a sub-stack of a select layer and a source layer for forming a select plate and a source plate, respectively, of the memory device. The select and source layers may hence form a bottom sub-stack of the layer stack 10. The select and source layers may be formed by conventional techniques and materials, e.g. doped semiconductor layers (e.g. polysilicon), and be separated by layers of interlayer dielectric.

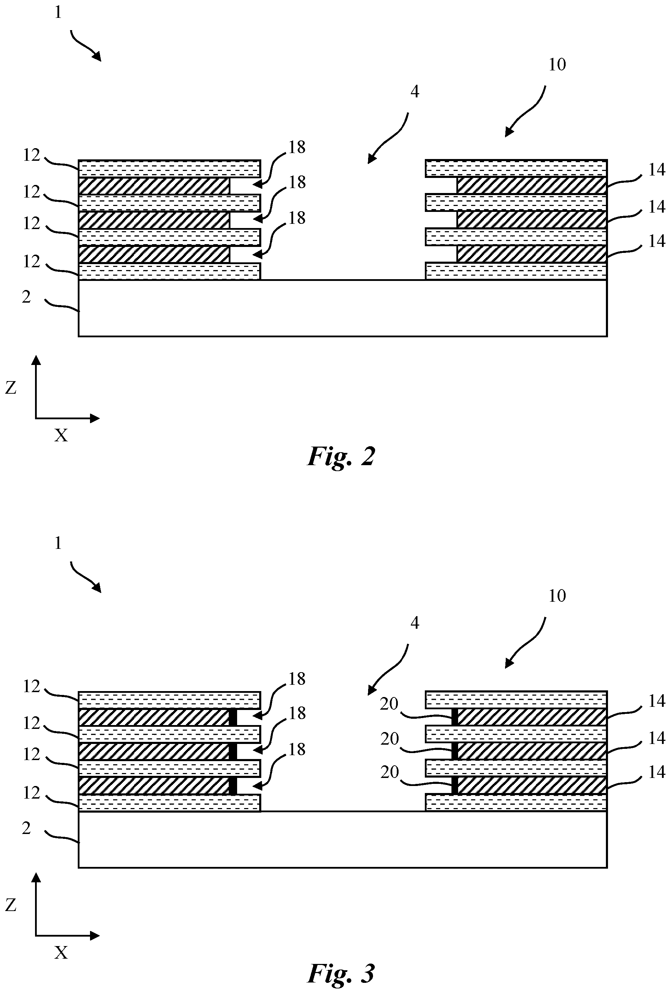

In Fig. 2, recessed areas 18 have been formed in a sidewall of the layer stack 10 surrounding the memory hole 4 by laterally etching back (i.e., in a radially outward direction, along the X-axis) the gate layers 14 relative to the inter-gate spacer layers 12 from the memory hole 4. Thereby, each recessed area / recess 18 is formed between a pair of inter-gate spacer layers 12. Due to the circumferential extension of the sidewall about the memory hole 4, the recessed areas 18 may extend circumferentially about the memory hole 4. In the example of a circular memory hole 4, the recessed areas 18 may be annular.

The gate layers 14 may be etched back using an etching process adapted to etch the gate layers 14 selectively to the inter-gate spacer layers 12. That is, the etching process may be adapted to etch (i.e. remove) the material (e.g. the silicon nitride, a-Si or polysilicon) of the gate layers 14 selectively to the material (e.g. the oxide material) of the gate layers 14, such that the gate layers 14 may be laterally etched back without causing any substantial etch-back of the inter-gate spacer layers 12. The etching process may be applied to the sidewall of the layer stack 10 via the memory hole 4. The etching process may be an isotropic etching process. However, any suitably selective etching process, wet or dry, providing a sufficient lateral etching component for the gate layers 14 may be used.

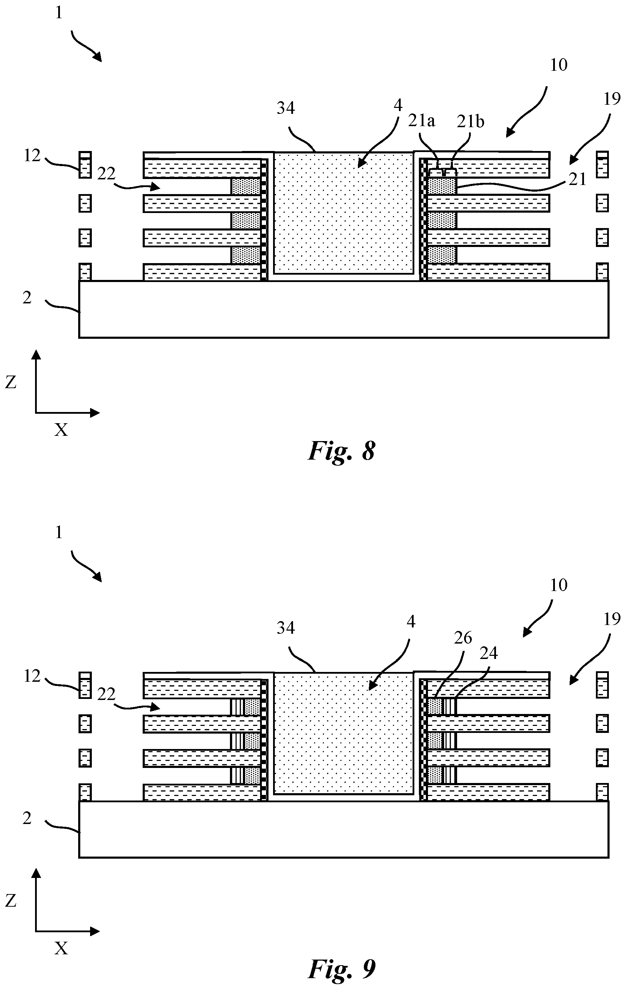

The recessed areas 18 may be formed with a lateral/radial depth (along the X-axis) meeting or exceeding an intended lateral thickness of the lateral memory stacks, e.g., a combined lateral thickness of the blocking oxide and charge trap layers at each gate-level (Fig. 9). As may be appreciated, the lateral depth of the recessed areas 18 is determined by the lateral depth (radial extent) of the lateral etch back. The lateral depth of the recessed areas 18 may for example be in a range of 6-20 nm. The depth of the recessed areas 18 may be controlled by timing the lateral etch back.

In Fig. 3, an etch stop layer 20 has been deposited on the etched-back gate layers 14 in the recessed areas 18. The etch stop layers 20 are discrete layers, each formed in a respective recessed area 18, e.g., on a respective gate layer 14.

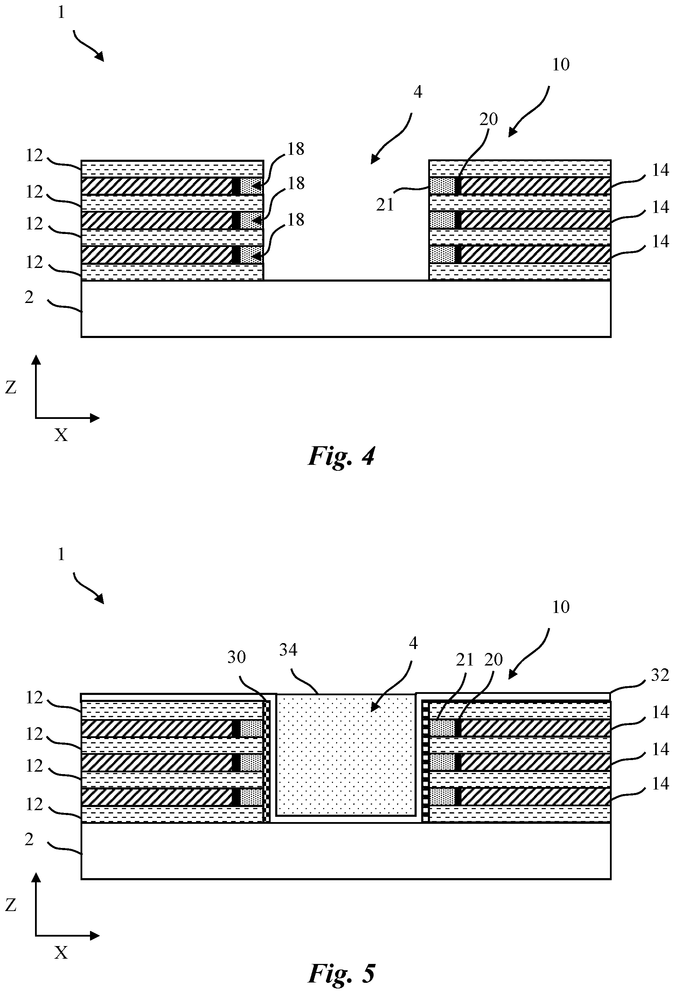

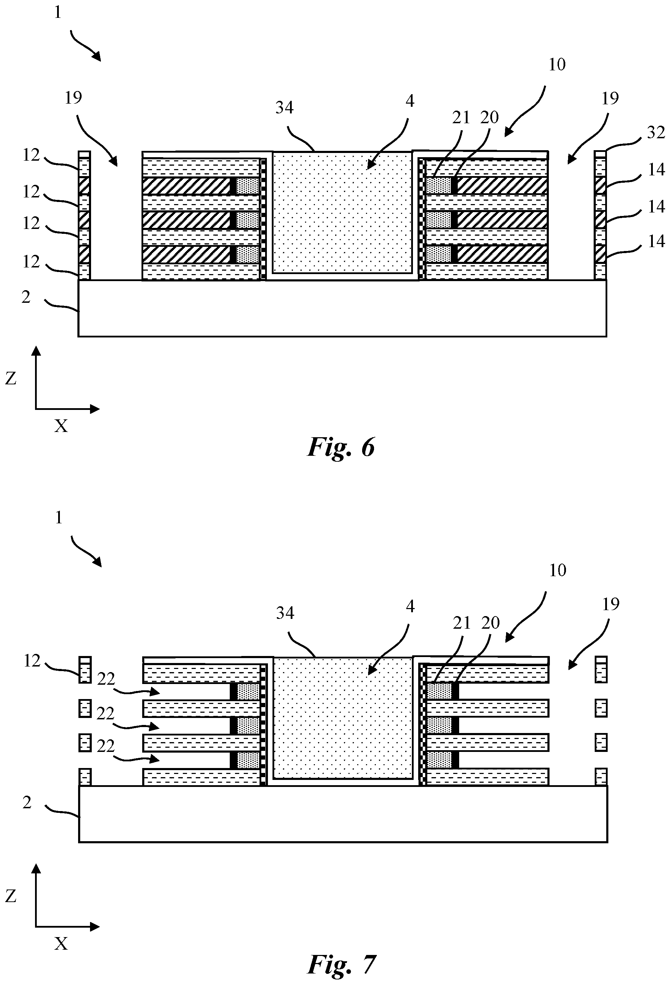

A purpose of the etch stop layers 20 are to function as etch stop layers during a subsequent step of gate cavity formation (Fig. 7). A further optional purpose of the etch stop layers 20 is to function as a seeding layer for ASD of charge trap material (Fig. 4). The etch stop layers 20 are further to be removed prior to forming blocking oxide layers (Fig. 9). Accordingly, the etch stop layers 20 are merely temporary process layers that will not have any function or be present in the final memory structure. Hence, the etch stop layers 20 may typically, as indicated in Fig. 3, be formed as relatively thin layers and need at any rate be no thicker than needed to provide this/these function(s).

Since the recessed areas 18 are further to accommodate initial charge trap layers 21 of some minimum target thickness, each etch stop layer 20 is deposited to only partially fill its associated recessed area 18. Hence, also subsequent to forming the etch stop layers 20, the sidewall of the memory hole 4 defines a recessed / profiled sidewall. The etch stop layers 20 are formed with a thickness which is smaller than a lateral depth (along the X axis) of the recessed areas 18. The thickness an etch stop layer 20 here refers to its lateral thickness, its thickness along the X axis, i.e., parallel to the in-plane direction of the gate layers 14. For instance, the etch stop layers 20 may be formed with a thickness of about 2 nm or less, such as about 1 nm. A thickness in this range is compatible with the above-mentioned ranges of depth of the recessed areas 18, and the below discussed thickness ranges of the initial charge trap layers 21.

The etch stop layer 20 may for example comprise, or be formed of, a metal oxide or a metal nitride, such as AlOₓ, HfOₓ, TiN, TiO₂, or some other material (e.g., high-k oxide or nitride) suitable to be used as a etch stop material. These materials may further facilitate ASD of charge trap material, described below.

The etch stop layers 20 may advantageously be deposited on the etched-back gate layer 14 in each recessed area 18 by an ASD process (a first ASD process). Thus, etch stop material for forming the etch stop layers 20 may be deposited selectively in the recessed areas 18. The deposition may be continued until discrete portions of etch stop material of a target thickness has been deposited in each recessed area 18, each portion defining a respective discrete etch stop layer 20. During the ASD, the etched-back end surfaces of the gate layers 14 facing the memory hole 4 may define deposition-promoting (seeding) areas for the etch stop material while the inter-gate spacer layers 12 define deposition-inhibiting (non-growth) areas. The etch stop material may be deposited using any suitable deposition process (e.g. an ALD or CVD process) facilitating ASD of the etch stop material in the recessed areas 18.

It is envisaged that typical material choices of the gate layers 14 (e.g., silicon nitride, a-Si or polysilicon) may provide sufficiently growth-promoting surfaces relative to the inter-gate spacer layers (e.g., silicon oxide) to facilitate ASD of the etch stop material (e.g. metal oxides or nitrides). However, to further facilitate ASD of the etch stop layers 20, the layer stack 10 may optionally be subjected to a treatment process prior to depositing the etch stop material, to define growth areas in the recessed areas 18 (e.g., on the end surfaces of the etched-back gate layers 14) and non-growth areas outside the recessed areas 18. The treatment process may be adapted to functionalize the surface portions / end surfaces of the etched-back gate layers 14 in the recessed areas 18 with respect to the ASD of the etch stop material. The treatment process may additionally or alternatively be adapted to passivate exposed surface portions of the inter-gate spacer layers 12 with respect to the ASD of the blocking oxide material. Thereafter the etch stop material may be deposited selectively in the growth areas in the recessed areas 18. For instance, the functionalization may comprise depositing a deposition-promoting layer on the end surfaces of the etched-back gate layers 14 in the recessed areas 18. Additionally or alternatively, the layer stack 10 may be subjected to a treatment process adapted to passivate exposed surface portions of the inter-gate spacer layers 12 with respect to the ASD of the etch stop material. For instance, some deposition processes favor deposition on hydrogen terminated surfaces (e.g. the deposition process deposits material preferentially on hydrogen terminated surfaces). A treatment process may hence be adapted to increase an occurrence of hydrogen terminated bonds on the gate layers 14 (thus promoting deposition thereon) and/or reduce an occurrence of hydrogen terminated bonds on the inter-gate spacer layers 12 (thus inhibiting deposition thereon). As a further example, silicon oxide (SiO₂) inter-gate spacer layers 12 can be passivated selectively to silicon nitride/a-Si/polysilicon gate layers 14 using siloxanes, aminosilanes, trichlorosilanes, small molecule inhibitors (SMIs, such as dimethylamino-trimethylsilane (DMA-TMS), trimethyltrimethoxysilane, trimethoxytrichlorosilane, etc.) or self-assembled monolayers (SAMs, such as alkylsilanes), to allow ASD of the etch stop material on the end surfaces of the gate layers 14.

Although using ASD to form the etch stop layers 20 may be advantageous, also a non-selective deposition of etch stop material may be used to form the etch stop layers 20. For instance, etch stop material may be deposited by a conformal and non-selective deposition process. Portions of the etch stop material deposited outside the recessed areas 18 may subsequently be removed by an anisotropic etching process biased in a direction (e.g., substantially top-down, in the -Z direction) such that the etch stop material deposited inside the recessed areas 18 may be shadowed from the etching chemistries by the overhang provided by the inter-gate spacer layers 12, at least on the etched-back end surfaces of the gate layers 14 which define the surface portions farthest from the memory hole 4. As the etch stop layers 20 may be formed as relatively thin layers (e.g., about 2 nm or less), portions of etch stop material that may remain on surface portions of the inter-gate spacer layers 12 within the recessed areas 18 may have a relatively minor impact on the available space for the initial charge trap layers 21. Additionally, a relatively brief etch step may suffice to remove charge trap material deposited outside the recessed areas 18. Alternatively, the non-selective deposition approach described below with respect to the charge trap material may be applied in a corresponding manner to realize a non-selective deposition of the etch stop material. In this case, the etch back of etch stop material may proceed until the etch stop material remains substantially only on the etched-back end surfaces of the gate layers 14, which define the surface portions farthest from the memory hole 4.

In Fig. 4, an initial charge trap layer 21 has been formed in each recessed area 18. The initial charge trap layers 21 are discrete layers, each formed in a respective recessed area 18, on a etch stop layer 21.

The initial charge trap layers 21 may be formed by an ASD process (a second ASD process) using the etch stop layer 20 as a seeding layer. Thus, charge trap material may be deposited selectively in the recessed areas 18, seeding from (nucleating on) the etch stop layers 20 therein.

The deposition of the charge trap material may be continued until discrete portions of charge trap material of a target thickness have been deposited in the recessed areas 18, each portion defining a respective discrete initial charge trap layer 21. During the ASD, the inter-gate spacer layers 12 define deposition-inhibiting (non-growth) areas while the etch stop layers 20 define deposition-promoting (seeding) areas for the charge trap material.

The charge trap material may comprise or be silicon nitride (SiN, i.e. Si₃N₄). Silicon nitride represents an efficient and rational realization of charge trap memory cells. Silicon nitride may for instance be deposited by ASD onto any of the above-mentioned examples of etch stop materials (metal oxides or metal nitrides such as AlOₓ, HfOₓ, TiN, TiO₂). More generally, the charge trap material may be or comprise silicon, meaning that the initial charge trap layers 21 may be silicon-comprising layers. The charge trap material may for example be silicon, meaning that the initial charge trap layers 21 may comprise or be silicon layers. Composite layer structures of the initial charge trap layers 21 are also possible. For example, the initial charge trap layers 21 may comprise first and second sequentially deposited layers (sub-layers), wherein the first sub-layer is a silicon or silicon-comprising layer, and the second sub-layer is a metal layer such as TiN or Ru. The first sub-layer will be the portion of the initial charge trap layers 21 exposed from the gate cavities 22 (Fig. 7). Thus, the first layer of each initial charge trap layer 21 may be a silicon-comprising or silicon layer such that the blocking oxide layers 24 may be formed by oxidation of the same, as described below. It is envisaged that ASD may be used also for other choices of charge trap material, as long as they may be deposited in an area-selective fashion on the etch stop layers 20 in the recessed areas 18, and may be oxidized to form blocking oxide layers 24. The charge trap material may be deposited using any suitable deposition process, conformal or non-conformal, such as an ALD or CVD process.

To facilitate the ASD of the charge trap material, the layer stack 10 may be subjected to a treatment process prior to depositing the charge trap material, to define growth areas in the recessed areas 18 (e.g., on the etch stop layers 20) and non-growth areas outside the recessed areas 18. The treatment process may be adapted to (further) functionalize the eth stop layers 20 with respect to the ASD of the charge trap material. The treatment process may additionally or alternatively be adapted to passivate exposed surface portions of the inter-gate spacer layers 12 with respect to the ASD of the charge trap material. Thereafter the charge trap material may be deposited selectively on the growth areas in the recessed areas 18. The examples of functionalization and passivation discussed above with reference to ASD of blocking oxide material apply correspondingly to ASD of charge trap material. As a specific non-limiting example, a SiO₂ surface may be passivated by DMA-TMS inhibition selectively to either TiO₂ or TiN.

Although using ASD to form the initial charge trap layers 21 may be advantageous, also a non-selective deposition of charge trap material may be used to form the initial charge trap layers 21. For instance, charge trap material may be deposited as a continuous layer by a conformal deposition process so as to completely fill (e.g., by pinch-off) the recessed areas 18. A local lateral thickness (along the X direction) of the charge trap material deposited in the recessed areas 18 may thereby exceed a local thickness of the charge trap material deposited outside the recessed areas 18. The charge trap material may subsequently be etched back (e.g., isotropically) such that the portions of the charge trap material deposited outside the recessed areas 18 are removed and such that portions of the charge trap material filling the recessed areas 18 remain to define discrete initial charge trap layers 21 therein.

At the present stage of the process, blocking oxide layers 24 (Fig. 9) are yet to be formed. Hence, at the stage of forming the initial charge trap layers, there has been no preceding deposition and etch-back of blocking oxide. Therefore, there may be less variability among the recessed areas 18 (e.g., in terms of depth, height and profile of the interior spaces of the recessed areas 18). More uniform recessed areas in turn facilitates both control of both deposition thickness and etch back of a continuous charge trap layer.

Regardless of whether the initial charge trap layers 21 are formed using an ASD or non-ASD process, the initial charge trap layers 21 may each be formed with a lateral thickness (along the X axis) in a range of about 6-20 nm (e.g., 6-20 nm minus the thickness of the etch stop layers 20). More generally, the initial charge trap layers 21 may be formed so as to completely fill the remaining interior spaces of the recessed areas 18 following the forming of the etch stop layers 20. End surfaces of the discrete initial charge trap layers 21 facing the memory hole 4 may thus become substantially flush with the end surfaces of the inter-gate space layers 12 facing the memory hole 4. In other words, a sidewall of the memory hole 4 may (e.g., again) be restored to a substantially straight profile, or at least with a reduced topography compared prior to forming the initial charge trap layers 21.

Thus, at the stage of the process illustrated in Fig. 4, each recessed areas 18 has been provided with (e.g., "re-filled" and/or "re-grown" with) an etch stop layer 20 and an initial charge trap layer 21.

In Fig. 5, a tunneling oxide layer 30, and subsequently a channel layer 32, have been formed in the memory hole 4, along the sidewall thereof. The tunneling oxide layer 30 is thus formed along the initial charge trap layers 21 of the lateral memory stacks, more specifically along or in contact with the respective radially inner end surfaces of the initial charge trap layers 21 facing the memory hole 4. The tunneling oxide layer 30 and the channel layer 32 may each be conformally deposited, e.g. using a respective ALD process. After depositing the tunneling oxide layer 30, the tunneling oxide layer 30 may be subjected to an anisotropic etch oriented top-down (opposite the direction of the Z-axis) to remove portions of the tunneling oxide layer 30 deposited on horizontally oriented surfaces of the structure 1.

The tunneling oxide layer 30 may be formed of any material conventionally used in the industry for tunneling oxide layers, one non-limiting example being SiON. The channel layer 32 may similarly be formed by any suitable channel material conventionally used in the industry for channel layers, typically a semiconductor material such as Si, SiGe or Ge. While not shown in Fig. 4, the channel layer 32 may present an extension outside of the illustrated portion of the structure 1, to facilitate connection to peripheral semiconductor devices and circuitry, such as select transistors.

Subsequent to forming the tunneling oxide and channel layers 30, 32, the memory hole 4 has been filled with a plug or filler material 34, such as an inter-layer dielectric (e.g., SiO₂) or other low-k dielectric. The plug material 34 may be deposited e.g., by CVD or physical vapor deposition (PVD). The structure 1 may subsequently be planarized (e.g., by chemical mechanical polishing (CMP)) to remove overburden plug material outside the memory hole 4, thus arriving at the structure 1 shown in Fig. 5.

In Fig. 6, an access trench 19 has been formed in the layer stack 10. The access trench 19 is formed in the layer stack 10 at a location outside of the memory hole 4, i.e., laterally/radially spaced apart from the memory hole 4. The access trench 19 extends through each of the inter-gate spacer and gate layers 12, 14 of the layer stack 10. The access trench 19 thus exposes an end surface of each gate layer 14 facing in a radially outward direction with respect to the memory hole 4. In the illustrated example, the access trench 19 is formed after the channel layer 32, and thus further extends through the channel layer 32. The access trench 19 may be patterned in the layer stack 10, e.g. by a lithography and etching process.

The access trench 19 may be formed to at least partially surround the memory hole 4. The access trench 19 may as shown be formed on opposite sides of the memory hole 4, e.g., as a two slit-shaped trench sections, or as a continuously extending trench. The access trench 19 may for example be formed to circumscribe (i.e., fully circumferentially surround) the memory hole 4. The access trench 19 may in this case have a cross-sectional footprint/shape (as seen in a top-down direction) corresponding to the memory hole 4. For example, where the memory hole 4 is circular the access trench 19 may be annular and substantially concentric with the memory hole 4, as a non-limiting example.

While Fig. 6 shows one access trench 19, it is noted that a corresponding access trench may be formed for each further memory hole 4 of the structure 1. It is further possible for neighboring memory holes to share an access trench. For instance, a pair of slit-shaped access trench sections may be formed on opposite sides of one or more rows of memory holes.

In Fig. 7, gate cavities 22 have been formed in the layer stack 10, between the inter-gate spacer layers 12, by laterally etching back the gate layers 14 from the access trench 19 in a direction towards the memory hole 4 (i.e., laterally, in a radially inward direction). The discussion of the lateral etch back of the gate layers 14 to form the recessed areas 18 applies correspondingly to the etching of the gate cavities 22. Thus, the etching process may be an isotropic etching process, or any other suitably selective etching process, wet or dry, providing a sufficient lateral etching component for the gate layers 14 may be used. For example, the gate cavities 22 may be etched using a same type of etching process as used to form the recessed areas 18. Owing to the lateral etching component of the etching process used to etch back the gate layers 14, the gate layers 14 may as shown further extend radially outward from the access trench 19, for instance toward one or more neighboring memory holes.

The etch back has been stopped (i.e., in the radially inward direction) on the etch stop layers 20 separating the initial charge trap layers 21 from the gate cavities 22. The etch stop layers 20 may in particular be used for etch-stop detection, however a timed etch back is also possible where the etch stop layers 20 may ensure that over-etching into the initial charge trap layers 21 is avoided. Further, since the locations of the etch stop layers 20 are determined by the depth of the etch back of the gate layers 14 for forming the recessed areas 18, the formation of the gate cavities 22 may be relatively insensitive to slight off-centered placements (e.g., non-concentric placements) of the access trench 19 relative to the memory hole 4, as may occur due to edge placement errors during lithographic patterning of the access trench 19.

Thus, at the stage of the process depicted in Fig. 7, radially and circumferentially extending gate cavities 22 have been formed at each gate level, wherein each gate cavity 22 is separated from the memory hole 4 (which here is filled with plug material 34) by a discrete etch stop layer 20 and a discrete initial charge trap layer 21. In the example of a circular memory hole 4, the gate cavities 22 may be annular.

In Fig. 8, the etch stop layer 20 has been opened (e.g., by a short isotropic etching step) to expose the initial charge trap layer 21 in each gate cavity 22, more specifically a radially outwardly facing end surface of each initial charge trap layer 21. The initial charge trap layers 21 have thereby been made accessible for the subsequent oxidation process.

In Fig. 9, a radially outer portion 21b (indicated in Fig. 8) of the initial charge trap layer 21 in each gate cavity 22 has been oxidized to form a discrete blocking oxide layer 24. A radially inner non-oxidized portion 21a (indicated in Fig. 8) of each initial charge trap layer 21 remains as shown to form a final charge trap layer 26 between the blocking oxide layer 24 and the memory hole 4. The initial charge trap layers 21 may be exposed to the oxidizing ambient/agent of the oxidation process via the gate cavities 22.

A discrete blocking oxide layer 24 has thereby been formed without necessitating a separate deposition and etching of a continuous blocking oxide layer. Further, the thickness of the blocking oxide layers 24 (i.e., lateral thickness along the X direction) may be precisely controlled via the oxidation depth of the initial charge trap layers 21. Assuming an initial thickness of the initial charge trap layers 21 in the above-mentioned example range, the oxidation depth, and thus the thickness of the blocking oxide layers 20, may for example be in a range of 4-15 nm, depending of course on an initial thickness of the initial charge trap layers 21 and a target thickness of the final charge trap layers 26.

Where the initial charge trap layers 21 are silicon-comprising layers, such as silicon nitride layers or Si/metal layers, the blocking oxide layers 24 may be formed as silicon oxide (SiO₂) layers.

The oxidation process may for example be a thermal oxidation process. The blocking oxide layers 20 may thus be formed by a thermal oxide. The oxide may be a low-temperature oxide (LTO) or a high-temperature oxide (HTO). An alternative to a thermal oxidation process is a plasma oxidation process.

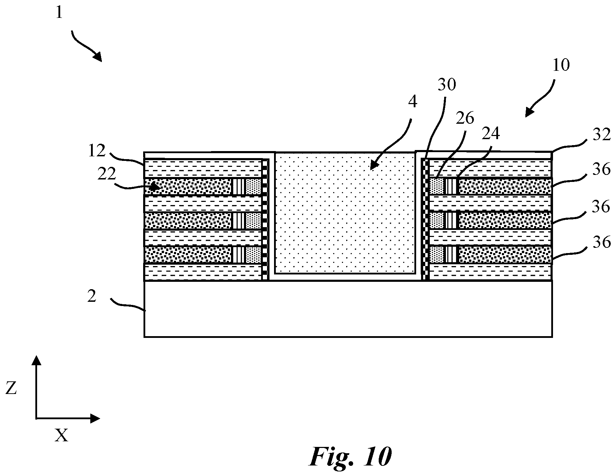

In Fig. 10, subsequent to forming the blocking oxide layer 24 and the final charge trap layers 26, final (functional) gate layers or stacks 36 have been formed in the gate cavities 22 by depositing gate material in the gate cavities 22 via the access trench 19. This may correspond to a gate layer/gate stack deposition of an RMG process. The gate material deposition may comprise depositing one or more conductive layers, e.g. metal such as one or more of TiN and W. The deposition of the conductive layer(s) may be preceded by deposition of a (conformal) high-k gate dielectric.

Thus, at the stage of the process illustrated in Fig. 10, a memory structure 1 has been formed comprising, for each gate level, a discrete blocking oxide layer 24 and a discrete charge trap layer 26. These layers define a lateral memory stack between a respective gate layer/stack 36 and the (shared) tunnel barrier and channel layers 30, 32.

The process may further proceed with conventional process steps of 3D NAND fabrication, as per se is known in the art. For example, the structure 1 may be further processed to contact each gate layer 36 to peripheral semiconductor devices and circuitry, such as select transistors and wordline drivers. Contact formation may for example be preceded with patterning the gate layers 36 into a staircase structure

While in the above, the access trench 19 and gate cavities 22 are formed subsequent to forming the tunnel barrier and channel layers 30, 32, the reverse order is also possible. For instance, after forming the initial charge trap layers 21, the memory hole 4 may be plugged with a temporary plug material. Subsequently, the access trench 19 and gate cavities 22 may be formed, the blocking oxide layers 24 may be formed by applying the oxidation process, and the gate cavities may be filled with gate material 36. Subsequently, the temporary plug material may be removed and the tunnel barrier and channel layers 30, 32 may be formed in the memory hole 4. However, it is envisaged that the at the illustrated order of forming the access trench 19 and gate cavities 22 subsequent to forming the tunnel barrier and channel layers 30, 32 results in an overall more efficient process.

Further, the illustrated example embodiments discussed above comprise forming of etch stop layers 20 prior to forming the initial charge trap layers 21. However, it is contemplated that a corresponding oxidation-based approach for forming the blocking oxide layers 24 may be used also in a process flow omitting such etch stop layers 20. According to this variation, the method may directly following forming of the recessed areas 18, proceed by forming discrete initial charge trap layers 21 in the recessed areas 18. The initial charge trap layers 21 may in this case be formed by ASD of charge trap material, seeding from the etched-back end surfaces of the gate layers 14 exposed in the recessed areas 18 (e.g., after functionalization and/or passivation of the gate layers 14 and inter-gate spacer layers 12, respectively). When forming the gate cavities 22 (Fig. 7) the etch-back of the gate layers 14 may accordingly be stopped on the initial charge trap layers 21. Hence, this approach may be more suited where the gate layers 14 and the charge trap layers 21 are formed of materials providing a sufficient contrast to the etching process used to form the gate cavities 22. However, this approach may in principle also be used where the gate material and the charge trap material provide little to no etch contrast provided the access trench 19 can be precisely aligned (e.g., concentrically) with the memory hole 4 and the etching process can be precisely timed, such that the initial charge trap layers 21 may be exposed along the full circumference of the memory hole 4 without over-etching in any radial direction.

The person skilled in the art realizes that the present invention by no means is limited to the embodiments described above. On the contrary, many modifications and variations are possible within the scope of the appended claims.

## Claims

1. A method for forming a memory structure (1) for a 3D NAND flash memory, the method comprising:
forming a layer stack (10) over a substrate (2), the layer stack (10) comprising an alternating sequence of gate layers (14) and inter-gate spacer layers (12);
forming recessed areas (18) in a sidewall surrounding a memory hole (4) in the layer stack (10) by laterally etching back the gate layers (14) relative to the inter-gate spacer layers (12) from the memory hole (4);
forming an initial charge trap layer (21) in each recessed area (18);
depositing a tunneling oxide layer (30) in the memory hole (4);
depositing a channel layer (32) on the tunneling oxide layer (30);
forming an access trench (19) in the layer stack (10);
forming gate cavities (22) in the layer stack (10) by laterally etching back the gate layers (14) from the access trench (19) in a direction towards the memory hole (4), wherein the gate cavities (22) expose the initial charge trap layers (21);
oxidizing a portion (21b) of the initial charge trap layer (21) in each gate cavity (22) such that the oxidized portion (21b) forms a blocking oxide layer (24) and a non-oxidized portion (21a) of the initial charge trap layer (21) remains to form a final charge trap layer (26) between the blocking oxide layer (24) and the memory hole (4); and
subsequent to forming the blocking oxide layers (24) and the final charge trap layers (26), forming gate layers (36) in the gate cavities (22) by depositing gate material in the gate cavities (22) via the access trench (19).

2. The method according to claim 1, further comprising:
prior to forming the initial charge trap layers (21), forming an etch stop layer (20) on the etched-back gate layers (14) in the recessed areas (18); and
subsequently depositing the initial charge trap layer (21) in each recessed area (18), on the etch stop layer (20);
wherein the etch back of the gate layers (14) from the access trench (19) is stopped on the etch stop layer (20), and
wherein the method further comprises, prior to oxidizing the portion (21b) of the initial charge trap layer (21) in each gate cavity (22), opening the etch stop layer (20) to expose the initial charge trap layer (21).

3. The method according to claim 2, wherein the etch stop layer (20) is deposited in each recessed area (18) by a first area-selective deposition process.

4. The method according to any one of claims 2-3, wherein the initial charge trap layer (21) is deposited on the etch stop layer (20) in each recessed area (18) by a second area-selective deposition process.

5. The method according to any one of the preceding claims, wherein the portion (21b) of the initial charge trap layer (21) is oxidized by a thermal oxidation process or a plasma oxidation process.

6. The method according to any one of the preceding claims, wherein the access trench (19) is formed after depositing the tunneling oxide layer (30) and the channel layer (32).

7. The method according to any one of the preceding claims, further comprising filling the memory hole (4) with a plug material (34) prior to forming the access trench (19).

8. The method according to claim 7, wherein the plug material (34) comprises an oxide.

9. The method according to any one of the preceding claims, when dependent on claim 2, wherein the etch stop layer (20) comprises a metal oxide or a metal nitride.

10. The method according to any one of the preceding claims, when dependent on claim 2, wherein the etch stop layer (20) is formed with a thickness of 2 nm or less.

11. The method according to any one of the preceding claims, wherein each initial charge trap layer (21) is a silicon-comprising layer, such as a silicon nitride layer.

12. The method according to any one of the preceding claims, wherein the inter-gate spacer layers (12) and the gate layers (14) are formed with respective layer thicknesses in a range of 5-25 nm.

13. The method according to claim 12, wherein a combined thickness of one inter-gate spacer layer (12) and one gate layer (14) is 45 nm or less.
